Europäisches Patentamt

European Patent Office

Office européen des brevets

(11) Publication number: **0 024 896**
**B1**

(12) **EUROPEAN PATENT SPECIFICATION**

(45) Date of publication of patent specification: **27.11.85**

(21) Application number: **80302913.1**

(22) Date of filing: **22.08.80**

(51) Int. Cl.⁴: **H 01 L 27/02, H 01 L 21/82,
H 03 K 19/091**

(54) **A semiconductor device and a method of manufacturing the device.**

(30) Priority: **27.08.79 JP 108938/79**

(43) Date of publication of application:
**11.03.81 Bulletin 81/10**

(45) Publication of the grant of the patent:
**27.11.85 Bulletin 85/48**

(84) Designated Contracting States:
**DE FR GB NL**

(56) References cited:
**FR-A-2 408 216**

**PATENTS ABSTRACTS OF JAPAN, vol. 1, no.
145, 25th November 1977, pages 7317E77,
Tokyo (JP);
IBM TECHNICAL DISCLOSURE BULLETIN, vol.
19, no. 7, December 1976, pages 2514-2516,
New York (USA); N.G.ANANTHA et al.:
"Fabrication of 12L circuits"**

(73) Proprietor: **FUJITSU LIMITED
1015, Kamikodanaka Nakahara-ku
Kawasaki-shi Kanagawa 211 (JP)**

(72) Inventor: **Fukuda, Takeshi
c/o Nakae Enomoto, 46-1 Higashitamagawa,
2-chome
Setagaya-ku, Tokyo, 158 (JP)**

(74) Representative: **Bedggood, Guy Stuart et al
Haseltine Lake & Co. Hazlitt House 28
Southampton Buildings Chancery Lane
London WC2A 1AT (GB)**

Courier Press, Leamington Spa, England.

## Description

The present invention relates to a semiconductor device and a method of manufacturing the device.

As is generally known in the art, in the main, Metal Oxide Semiconductor (MOS) integrated circuits and bipolar integrated circuits are used to make up semiconductor digital logic circuits. Bipolar integrated circuits have complex structures and have a limited packing density, but have a comparatively high switching speed. The disadvantage of bipolar integrated circuits is compensated for in $I^2L$ (integrated injection logic) devices in which are relatively simple in structure with a high function density and with much less consumption of electric power.

A typical general purpose, n-p-n, planar monolithic bipolar transistor is fabricated in an epitaxial n-type layer grown on an $n^+$ buried layer (i.e. a n-type layer of relatively higher doping) supported by a p-type substrate, and is electrically isolated from other components in the layer by p-type diffusions through the epitaxial layer to the substrate. This isolation of parts of an epitaxial n-type layer by means of p-type diffusions is essential for the fabrication of a bipolar transistor. In this regard, $I^2L$ devices can be fabricated without such p-type diffusions, which means that manufacturing process is simplified. This is why $I^2L$ devices can compete with MOS integrated circuits.

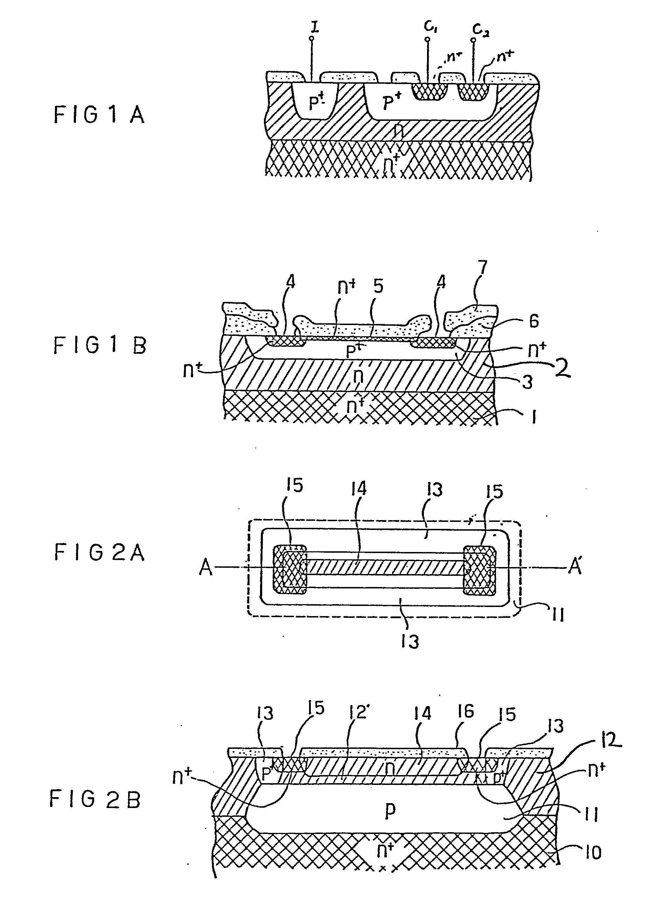

A typical $I^2L$ device is shown in cross-section in Fig. 1A of the accompanying drawings which is a schematic cross-sectional view of such a device. An epitaxial n-type layer is supported by an $n^+$ substrate, and p-type diffusions through the epitaxial layer form $p^+$ regions (i.e. p-type regions of relatively high doping) for an injector I and a base region. An n-type diffusion through the base forms $n^+$ regions for collectors C1 and C2. As will be understood from Fig. 1A, the illustrated $I^2L$ device is formed to have a vertical pn junction structure, and if an electrical voltage of order 5—6 volts is applied and a vertical pn junction is forwardly biased electric current flows downwardly through, and from, the p-type region (i.e. $p^+$) of the junction. In other words, the p-type region is not isolated from the n-type region. Because of this, a diffused p-type region does not function properly as a resistor layer.

In order to overcome the problem just described above, it is general practice in the art to form a resistor layer of n-type in a p-type region which is formed simultaneously with the formation of a base region.

Fig. 1B of the accompanying drawings illustrates in cross-section a resistor layer formed in accordance with a conventional technique. An epitaxial n-type layer 2 is formed on an $n^+$ silicon substrate 1, and a $p^+$ region 3 is formed simultaneously with the formation of a base region. Then, $n^+$ electrode connections 4 for a resistor layer are formed simultaneously with the formation of an emitter region. Thereafter, a window is opened through an oxide film 6 to the region where a resistor layer is to be formed and impurities such as phosphorus or arsenic are diffused by conventional ion implantation fabrication technologies through the window, and when a subsequent heat treatment is completed, a resistor layer 5 is formed.

Formation of a resistor layer as in Fig. 1B presents some new problems while overcoming the initial problem mentioned before relating to Fig. 1A.

Firstly, the resistor layer must be formed in a diffused region which is formed simultaneously with the base region of high impurity concentration by diffusion of impurities of higher impurity concentration in the same manner as with the formation of the emitter region, so that the withstand voltage of the resistor layer is relatively low. On the other hand, it is advantageous to provide an input resistance in an $I^2L$ type device, when impedance is taken into consideration, but in a case in which the device is to receive an input from an Transistor-Transistor Logic (TTL) circuit, an input resistor having the withstand voltage of several volts is required. This presents the problem of fabrication of a resistor layer with a high withstand voltage.

Secondly, a resistor layer of the depth of 0.2 μm or less is separately formed by ion implantation of $1 \times 10^{15}/cm^2$ dose after fabrication of the emitter region as described above in order to attain a high-value resistance of order 500—600 $\Omega/\square$. Since heat treatment is carried out subsequently to ion implantation, the depth of the emitter region or the width of the base region already formed is changed. This affects the current gain factor hFE that has been previously determined, and it is difficult in this case to control this hFE to have a desired value.

Thirdly, after the resistor layer has been fabricated, the region where the resistor layer is located is not covered by an oxide film, and thus is exposed. In order to cover the region, an oxide film 7 (see Fig. 1B) is deposited by a conventional chemical vapour deposition. Then, as shown in the Figure 1B, the surface of the semiconductor device has a two tiered structure with a lower oxide layer 6 containing a considerable amount of impurities, of phosphorus for example, adhering thereto due to diffusion of the emitter region and formation of the resistor layer, and an upper oxide film 7 deposited by chemical vapour deposition as described above with a much lesser amount of impurities adhering thereto. In an etching operation for opening a window for the connection of an electrode, the lower oxide layer 6 is side etched as shown in Fig. 2 because it is etched at a higher rate (than film 7) due to impurities. When an electrode of aluminium, for example, is formed in the emitter region through the window, the electrode is likely to be open or broken where the lower oxide layer is side etched because of its poor coverage there.

Formation of the resistor layer according to the conventional technique thus involves a number of problems.

JP—A—52 83 078 discloses a semiconductor device including an integrated injection logic device and a resistor element, having a semiconductor substrate of a first conductivity type, and a semiconductor layer of the first conductivity type formed on the semiconductor substrate. A buried layer structure is provided between the semiconductor substrate and the semiconductor layer, in which, in effect, two buried layers of a second conductivity type are separated by a further buried layer, of the first conductivity type. A diffusion region, of the second conductivity type, extends through the semiconductor layer to the buried layer of second conductivity type which is on the semiconductor layer side of the further buried layer, to surround an area of the semiconductor layer above the buried layers.

The surrounded area itself forms a resistor zone in which resistor contact regions of the first conductivity type are formed.

JP—A—52 83 078 discloses a method of forming such a semiconductor device.

FR—A—2 408 216 discloses a resistor zone in a semiconductor device overlying only a single buried layer.

According to one aspect of the present invention there is provided a semiconductor device including an integrated injection logic device and a resistor element comprising:

a semiconductor substrate of a first conductivity type;

a semiconductor layer of the first conductivity type, the semiconductor layer being formed on the semiconductor substrate;

a buried layer of a second conductivity type, opposite to the first conductivity type, the buried layer being between the semiconductor substrate and the semiconductor layer;

a diffused region of the second conductivity type, the diffused region extending through the semiconductor layer to the buried layer and surrounding an area of the semiconductor layer on the buried layer,

a resistor region of the first conductivity type, formed in the said area surrounded by the diffused region, the resistor region having a higher impurity concentration then the said semiconductor layer, and

means for electrically connecting the resistor region to wirings of the semiconductor device.

According to another aspect of the present invention there is provided a method of manufacturing a semiconductor device which device includes an integrated injection logic device and a resistor element, which method includes a process for forming the resistor element comprising the steps of:

preparing a semiconductor substrate portion of a first conductivity type;

introducing impurity atoms of a second conductivity type opposite to the first conductivity type into the semiconductor substrate for the purpose of forming a buried layer;

forming a semiconductor layer of the first conductivity type on the semiconductor substrate;

introducing impurity atoms of the second conductivity type into a ring-shaped region of the semiconductor layer extending to the buried layer, simultaneously with introduction of impurity atoms into the semiconductor substrate for forming a base region of the integrated injection logic device,

introducing impurity atoms of the first conductivity type into a pair of regions within the area inside the ring-shaped region, simultaneously with introduction of such impurity atoms into the semiconductor substrate for forming a collector region of the integrated injection logic device, and including the step of

introducing impurity atoms of the first conductivity type into the said area inside the ring-shaped region to form a resistor region in that area before formation of the collector region or formation of the base region of the integrated injection logic device, that said pair of regions providing means for electrical connection of wirings of the semiconductor device to the resistor region.

The present invention is concerned with the manufacture and structure of a semiconductor device having an $I^2L$ device and a resistor layer with as few difficulties as possible in connection with the problems enumerated above. To this end, in a semiconductor device embodying the present invention a region of the same conductivity type as the semiconductor substrate is formed so as to reach a buried layer of the opposite conductivity type to that of the semiconductor substrate, that region being surrounded by a diffused region of the opposite conductivity type, and then a resistor layer is formed in the region. In a semiconductor device thus formed, a resistor layer having a desired resistance can be formed whilst avoiding the need to form an oxide film such as tended to cause breaking of electrode connections in the conventional art. In addition, the established current gain factor, which determines the characteristics of the semiconductor device, is not affected by the steps of forming the resistor layer according to the present invention, and is maintained at a desired fixed value. Since it is not necessary to deposit an oxide film by the chemical vapour deposition technique as was required in the conventional art, the manufacturing process is simplified.

Reference is made, by way of example, to the accompanying drawings, in which:—

Fig. 1A, as mentioned above, is a cross-sectional view illustrating a typical previously proposed $I^2L$ semiconductor device;

Fig. 1B, as mentioned above, is a cross-sectional view illustrating a resistor element formed in accordance with a conventional technique;

Fig. 2A is a plan view of a resistor element formed in accordance with the present invention;

Fig. 2B is a cross-sectional view taken along the line A—A' of Fig. 2A; and

Figures 3A to 3D are cross-sectional views illustrating manufacturing steps according to the present invention.

A resistor element formed in accordance with the present invention is shown in plan view in Fig. 2A and in the cross-sectional view of Fig. 2B which is taken along the line A—A' of Fig. 2A.

A p-type buried layer 11 is formed on an N⁺ type (n-type with relatively high doping) silicon substrate 10 by a conventional process, and an epitaxial n-type layer marked 12, 12' is fabricated on the entire surface of the substrate 10 including the p-type buried layer 11, also by a conventional process. A resistor layer 14 is formed in the epitaxial n-type layer 12' and is isolated by the p-type buried layer 11 and a p⁺ type region 13 of a ring shape to be described hereafter, as best seen in the plan view of Fig. 2A. After the resistor layer 14 has been fabricated, an oxide film 16 is formed to cover the surface of the substrate shown, with windows opened therein for the connection of electrodes; n⁺ type regions 15 are electrode connection regions. Since the epitaxial layer itself has a sheet resistance of several kΩ/□ a high-value diffused resistor layer can easily be fabricated. Furthermore, as the resistor layer 14 is formed in epitaxial layer 12' which is of low impurity concentration, the withstand voltage of the resistor layer is much higher than that of the conventional resistor layer.

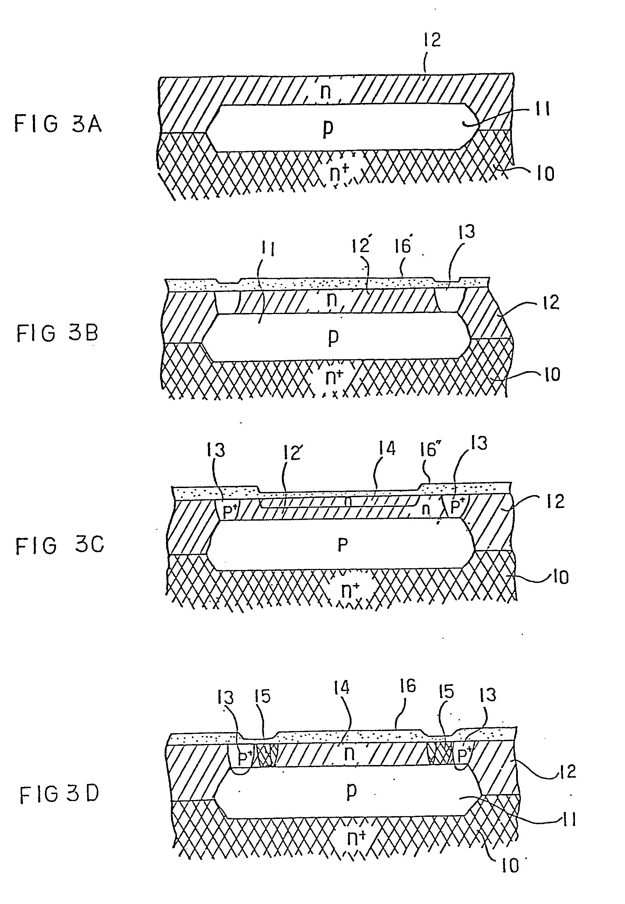

Steps for manufacturing a semiconductor device according to the present invention will now be explained with reference to Figures 3A to 3D which illustrate successive manufacturing steps in cross-section.

As shown in Fig. 3A, impurities such as boron are diffused into an n⁺ type silicon substrate 10 by a conventional ion implantation technique or by vacuum evaporation to form a p-type layer 11. An epitaxial n-type layer 12 is deposited on the surface of the substrate including the layer 11 by a known chemical vapour deposition. Impurities in the p-type layer 11 are diffused upwardly into the epitaxial layer 12 and present a profile as shown in Figure 3A due to the heat applied to the silicon substrate for heat treatment in the course of chemical vapour deposition and the heat applied in subsequent heat treatments. The diffused layer then becomes buried layer 11 having the profile as shown.

An n⁺ type diffusion layer is formed in the I²L device for the purpose of channel cut-off, then a base region of the I²L device is formed by diffusion. Simultaneously with the formation of the base region, a p⁺ type region 13 is fabricated in a ring shape as illustrated in Fig. 2A and Fig. 3B on the p-type buried layer 11, such that the bottom of the region 13 is in contact with the p-type buried layer 11, using an oxide film 16'. (The oxide film 16' is shown in the condition which it achieves after heat treatment of the substrate). Through these steps, a central epitaxial n-type layer 12' is completely isolated from the surrounding epitaxial layer 12.

Now, an n-type resistor layer 14 is formed as shown in Fig. 3C in the isolated epitaxial layer 12' for example by introducing phosphorus by a conventional ion implantation or diffusion technique for instance, using an oxide film 16''. (The oxide film 16'' is also shown in a condition after heat treatment of the substrate). This process is carried out quite apart from the fabrication of the I²L device, so that the process may be carried out before fabrication of the base region by diffusion. Moreover, it is possible to obtain a high-value diffused resistor layer 14 without having to make the layer shallow as has been done according to conventional technique.

The resistor layer may be provided through the isolated epitaxial layer 12'.

Simultaneously with the formation of the collector region of the I²L device, connections 15 of n⁺ type for electrodes are formed, as shown in Fig. 3D, by diffusion of n⁺ impurities and using an oxide film 16'''. (Again, the oxide film 16''' is shown in a condition after heat treatment of the substrate). Connections 15 for electrodes are in contact with the resistor layer 14, and may also be in contact with p⁺ type region 13 formed in a ring shape so as to surround the resistor layer 14. (They are shown in contact in Fig. 2B, but not in Fig. 30).

After these processes are over, oxidation, window cutting and metallisation are carried out in accordance with a known conventional techniques so as to form electrode wiring, and details of these steps will be omitted for brevity.

The present invention involves a method of forming an n-type resistor layer in an epitaxial n-type layer. The sheet resistance of the epitaxial layer is high as compared with the sheet resistance of the resistor layer, so that the sheet resistance of the epitaxial layer can be neglected.

As will be understood from the foregoing description, a resistor layer is formed in an epitaxial layer of which the bottom and sides are completely isolated by a conductive layer of opposite conductivity type to that of the substrate according to the present invention, so that the withstand voltage of the resistor layer/silicon substrate structure is high. As the sheet resistance of the epitaxial layer is in the range several kΩ/□, it is easy to obtain a resistance of low-value in the order of 100Ω/□ or a resistance of a high-value in the order of 3KΩ/□.

What has been disclosed relates to the manufacture of a resistor region which is formed before fabrication of the collector region in the I²L device, so that the width of the base region is not altered and the desired current amplification factor hFE can be maintained. Furthermore, an oxide film is formed on the surface of the resistor layer by heat treatment, and this eliminates the need for formation of an additional oxide film by conventional chemical vapour deposition. Because of this, there will be no danger of failure of the metallization coverage such as was caused by uneven etching of two layers making up the surface of the substrate slice as was described before.

In the embodiment shown in detail in Figures 3A to 3D and explained in the foregoing description, the p-type buried layer 11 was originally 0.3 μm thick and finally became 1.5 μm deep. The width of $p^+$ type diffusion 13 seen in Fig. 3B was 3.0 μm. The depth of epitaxial n-type layer 12 was 2.0 μm, and that of the resistor layer 14 and the $n^+$ type diffusion 15,0. 7 μm respectively.

As has been described, the present invention is suitable for fabrication of high-value input resistor element having the withstand voltage of several volts in a semiconductor device comprising a $I^2L$ device, has a wide range of applications and serves the purpose of expanding the potential fields of application of $I^2L$ devices.

Thus, an embodiment of the present invention provides a device in which a p-type buried layer is formed on an $n^+$ type silicon substrate by diffusion of boron for example, an epitaxial n-type layer is grown on the p-type buried layer, a $p^+$ type region is formed in a ring shape to surround the epitaxial n-type layer on the buried layer with the bottom of the $p^+$ region reaching to the p-type buried layer, an n-type resistor layer is formed in the epitaxial n-type layer by diffusion of phosphorus for example, and connections for electrodes are formed by diffusion of $n^+$ type impurities in such a manner that the connections make contact with the resistor layer.

## Claims

1. A semiconductor device including an integrated injection logic device and a resistor element, comprising:

a semiconductor substrate (10) of a first conductivity type;

a semiconductor layer (12) of the first conductivity type, the semiconductor layer (12) being formed on the semiconductor substrate (10);

a buried layer (11) of a second conductivity type, opposite to the first conducitivity type, the buried layer (11) being between the semiconductor substrate (10) and the semiconductor layer (12);

a diffused region (13) of the second conductivity type, the diffused region (13) extending through the semiconductor layer (12) to the buried layer (11) and surrounding an area (12') of the semiconductor layer (12) on the buried layer (11);

a resistor region (14) of the first conductivity type, formed in the said area (12') surrounded by the diffused region (13), the resistor region (14) having a higher impurity concentration than the said semiconductor layer (12), and

means (15) for electrically connecting the resistor region to wirings of the semiconductor device.

2. A semiconductor device as claimed in claim 1, wherein the semiconductor substrate (10) is an $n^+$ type substrate, the buried layer (11) is a p-type layer, the semiconductor layer (12) is an epitaxial n-type layer grown on the buried layer (11), and the diffused region (13) is a p-type diffused region.

3. A semiconductor device as claimed in claim 1 or 2, wherein the said means for electrically connecting comprises a pair of diffused regions (15) of the first conductivity type, that pair of diffused regions (15) being formed in the area surrounded by the diffused region (13) of the second conductivity type.

4. A method of manufacturing a semiconductor device which device includes an integrated injection logic device and a resistor element, which method includes a process for forming the resistor element comprising the steps of:

preparing a semiconductor substrate portion (10) of a first conductivity type;

introducing impurity atoms of a second conductivity type opposite to the first conductivity type into the semiconductor substrate for the purpose of forming a buried layer (11);

forming a semiconductor layer (12) of the first conductivity type on the semiconductor substrate;

introducing impurity atoms of the second conductivity type into a ring-shaped region (13) of the semiconductor layer extending to the buried layer (11), simultaneously with introduction of such impurity atoms into the semiconductor substrate for forming a base region of the integrated injection logic device,

introducing impurity atoms of the first conductivity type into a pair of regions (15) within the area (12') inside the ring-shaped region (13), simultaneously with introduction of such impurity atoms into the semiconductor substrate for forming a collector region of the integrated injection logic device, and including the step of

introducing impurity atoms of the first conductivity type into the said area (12') inside the ring-shaped region (13) to form a resistor region (14) in that area before formation of the collector region or formation of the base region of the integrated injection logic device, the said pair of regions (15) providing means for electrical connection of wirings of the semiconductor device to the resistor region.

## Patentansprüche

1. Halbleitervorrichtung mit einer integrierten Injektionslogikeinrichtung und einem Widerstandselement, mit:

einem Halbleitersubstrat (10) von einem ersten Leitfähigkeitstyp;

einer Halbleiterschicht (12), die vom ersten Leitfähigkeitstyp ist und auf dem Halbleitersubstrat (10) gebildet ist;

einer vergrabenen Schicht (11), die von einem zweiten, zum ersten Leitfähigkeitstyp entgegengesetzten Leitfähigkeitstyp ist und zwischen dem Halbleitersubstrat (10) und der Halbleiterschicht (12) angeordnet ist;

einem diffundierten Bereich (13) vom, zweiten Leitfähigkeitstyp, der sich durch die Halbleiterschicht (12) zu der vergrabenen Schicht (11) erstreckt und einen Bereich (12') der Halbleiterschicht (12) auf der vergrabenen Schicht (11) umgibt;

einem Widerstandsbereich (14) vom ersten Leitfähigkeitstyp, welcher in dem genannten Bereich (12') gebildet ist, der von dem diffundierten Bereich (13) umgeben ist, und welcher Widerstandsbereich (14) eine höhere Verunreinigungskonzentration als die genannte Halbleiterschicht (12) hat, und

Einrichtungen (15) zur elektrischen Verbindung des Widerstandsbereiches mit Verdrahtungen der Halbleitervorrichtung.

2. Halbleitervorrichtung nach Anspruch 1, bei welcher das Halbleitersubstrat (10) ein n$^+$-Typ-Substrat ist, die vergrabene Schicht (11) eine p-Typ-Schicht ist, die Halbleiterschicht (12) eine epitaktische n-Typ-Schicht ist, welche auf der vergrabenen Schicht (11) aufgewachsen ist, und der diffundierte Bereich (13) ein p-Typ-Diffusionsbereich ist.

3. Vorrichtung nach Anspruch 1 oder 2, bei welcher die genannte Einrichtung zur elektrischen Verbindung ein Paar von diffundierten Bereichen (15) umfaßt, die vom ersten Leitfähigkeitstyp und in dem Bereich gebildet sind, der von dem diffundierten Bereich (13) vom zweiten Leitfähigkeitstyp umgeben ist.

4. Verfahren zur Herstellung einer Halbleitervorrichtung, welche eine integrierte Injektionslogikeinrichtung und ein Widerstandselement umfaßt, welches Verfahren einen Prozeß zur Bildung des Widerstandselementes einschließt, der die folgenden Schritte umfaßt:

Vorbereitung eines Halbleitersubstratabschnitts (10) von einem ersten Leitfähigkeitstyp;

Einführung von Verunreinigungsatomen von einem zweiten, zum ersten Leitfähigkeitstyp entgegengesetzten Leitfähigkeitstyp in das Halbleitersubstrat, zum Zwecke der Bildung der vergrabenen Schicht (11);

Bildung einer Halbleitersubstratschicht (12) von dem ersten Leitfähigkeitstyp in dem Halbleitersubstrat;

Einführung von Verunreinigungsatomen von dem zweiten Leitfähigkeitstyp in einen ringförmigen Bereich (13) der Halbleiterschicht, welcher sich zu der vergrabenen Schicht (11) erstreckt, gleichzeitig mit der Einführung von solchen Verunreinigungsatomen in das Halbleitersubstrat, um einen Basisbereich der integrierten Injektionslogikeinrichtung zu bilden,

Einführung von Verunreinigungsatomen vom ersten Leitfähigkeitstyp in ein Paar von Bereichen (15) innerhalb des Bereiches (12') innerhalb des ringförmigen Bereiches (13), gleichzeitig mit der Einführung von solchen Verunreinigungsatomen in das Halbleitersubstrat zur Bildung eines Kollektorbereichs der integrierten Injektionslogikeinrichtung, und einschließlich des Schrittes der

Einführung von Verunreinigungsatomen von dem ersten Leitfähigkeitstyp in den genannten Bereich (12') innerhalb des ringförmigen Bereiches (13), um einen Widerstandsbereich (14) in dem Bereich zu bilden, vor Bildung des Kollektorbereichs oder Bildung des Basisbereichs der integrierten Injektionslogikeinrichtung, wobei das genannte Paar von Bereichen (15) Einrichtungen zur elektrischen Verbindung von Verdrahtungen der Halbleitervorrichtung des Widerstandsbereiches umfaßt.

**Revendications**

1. Dispositif semiconducteur comportant un dispositif logique à injection intégré et un élément résistant, comprenant:

un substrat semiconducteur (10) d'un premier type de conductivité;

une couche semiconductrice (12) du premier type de conductivité, la couche semiconductrice (12) étant formée sur le substrat semiconducteur (10);

une couche enterrée (11) d'un deuxième type de conductivité, opposé au premier type de conductivité, la couche enterrée (11) se trouvant entre le substrat semiconducteur (10) et la couche semiconductrice (12);

une région diffusée (13) du deuxième type de conductivité, la région diffusée (13) s'étendant au travers de la couche semiconductrice (12) jusqu'à la couche enterrée (11) et entourant une aire (12') de la couche semiconductrice (12) sur la couche enterrée (11);

un région résistante (14) du premier type de conductivité, formée dans ladite aire (12') entourée par la région diffusée (13), le région résistante (14) ayant une concentration en impureté plus élevée que ladite couche semiconductrice (12), et

un moyen (15) permettant de connecter électriquement la région résistante à des câblages du dispositif semiconducteur.

2. Dispositif semiconducteur selon la revendication 1, où le substrat semiconducteur (10) est un substrat de type n$^+$, la couche enterrée (11) est une couche de type p, la couche semiconductrice (12) est une couche de type n épitaxiale réalisée par croissance sur la couche enterrée (11), et la région diffusée (13) est une région diffusée de type p.

3. Dispositif semiconducteur selon la revendication 1 ou 2, où ledit moyen de connexion électrique comprend une paire de régions diffusées (15) du premier type de conductivité, cette paire de régions diffusées (15) étant formée dans l'aire entourée par la région diffusée (13) du deuxième type de conductivité.

4. Procédé de fabrication d'un dispositif semiconducteur, lequel dispositif comporte un dispositif logique à injection intégré et un élément résistant, lequel procédé comporte un processus de formation d'un élément résistant comprenant les opérations suivantes:

préparer une partie de substrat semiconducteur (10) d'un premier type de conductivité;

introduire des atomes d'impureté d'un deuxième type de conductivité, opposé au premier type de conductivité, dans le substrat semiconducteur dans le but de former une couche enterrée (11);

former une région semiconductrice (12) du premier type de conductivité sur le substrat semiconducteur;

introduire des atomes d'impureté du deuxième type de conductivité dans une région annulaire (13) de la couche semiconductrice s'étendant jusqu'à la couche enterrée (11), tandis que sont introduits de semblables atomes d'impureté dans le substrat semiconducteur en vue de la formation d'une région de base du dispositif logique d'injection intégré;

introduire des atomes d'impureté du premier type de conductivité dans une paire de régions (15) à l'intérieur de l'aire (12') interne à la région annulaire (13), en même temps que sont introduits de semblables atomes d'impureté dans le substrat semiconducteur en vue de la formation d'une région de collecteur du dispositif logique à injection intégré, et comportant l'opération suivante:

introduire des atomes d'impureté du premier type de conductivité dans ladite aire (12') à l'intérieur de la région annulaire (13) afin de former une région résistante (14) dans cette aire avant la formation de la région de collecteur ou la formation je la région de base du dispositif logique à injection intégré, ladite pair de régions (15) fournissant um moyen de connexion électrique de câblages du dispositif semiconducteur avec la région résistante.

FIG 1 A

FIG 1 B

FIG 2A

FIG 2B

FIG 3A

FIG 3B

FIG 3C

FIG 3D